# NEUE EUROPÄISCHE PATENTSCHRIFT

(11) **EP 2 727 880 B2**
(45) Veröffentlichungstag und Bekanntmachung des Hinweises auf die Entscheidung über den Einspruch: **07.08.2019**
(45) Hinweis auf die Patenterteilung: 08.06.2016
(21) Anmeldenummer: 12191327.1
(22) Anmeldetag: 05.11.2012
(51) Int. Cl.: B81B 3/00, B81C 1/00

(54) **Dreidimensionales, mikromechanisches Bauteil mit einer Fase und Verfahren zu dessen Herstellung**
Three-dimensional, micromechanical component having chamfer and method for its production
Composant micromécanique tridimensionnel chanfreiné et son procédé de fabrication

(43) Veröffentlichungstag der Anmeldung: 07.05.2014
(73) Patentinhaber: GFD Gesellschaft für Diamantprodukte mbH, 89081 Ulm (DE); Diamaze Microtechnology S.A., 2300 La Chaux-de-Fonds (CH)
(72) Erfinder: Gluche, Peter, 89287 Bellenberg (DE); Gretzschel, Ralph, 89231 Neu-Ulm / Offenhausen (DE)
(74) Vertreter: Pfenning, Meinig & Partner mbB

(56) Entgegenhaltungen:
- EP-A1- 1 835 050
- EP-A1- 2 120 105
- CH-A2- 699 476
- CH-B1- 700 032
- CH-B1- 700 032
- JP-A- 2010 188 468
- US-A1- 2010 278 368

## Beschreibung

Die Erfindung betrifft ein dreidimensionales, mikromechanisches Bauteil aus einem C- oder Si-enthaltenden Basismaterial, das sich dadurch auszeichnet, dass in den Flanken eines derartigen Bauteils, ausgehend von mindestens einer Oberflächenkante mindestens einer Oberfläche, in der/den Seitenkante/n eine Fase angeordnet ist, die einen Winkel α₁ von 40° bis 65° aufweist. Die Erfindung betrifft weiterhin ein Verfahren zur Herstellung eines derartigen Bauteils, wobei das vorstrukturierte Bauteil auf einem Wafer bzw. über Haltestege in einem Wafer befestigt ist und die Fase durch Sputtern und/oder durch Ionen- bzw. Plasmaätzen eingebracht wird.

Mikromechanische Bauteile, insbesondere Bauteile für Uhrwerke wie z.B. Bestandteile des Räderwerks oder Bestandteile der Hemmung, die aus Materialien wie Stahl, Messing oder Buntmetallen bestehen, sind im Stand der Technik bekannt. Im Bereich von Funktionsteilen für Uhrwerke ist es auch bekannt, derartige Bauteile mit einer Fase zu versehen (anglierte Bauteile). Bei Achsen wird eine derartige Fase direkt angedreht und bei Rädern erfolgt das Ausbilden der Fasern üblicherweise durch eine nachträgliche mechanische Bearbeitung. Die Vorteile von derartigen Bauteilen sind vielfältig:
1. Vermeidung von scharfen Kanten, welche durch Manipulation der Bauteile schnell zu Defekten werden (Grataufwurf, Einkerbungen). Damit einhergehend Erhöhung der mechanischen Stabilität.
2. Vermeidung von Gratbildung.
3. Verschiebung des Belastungspunktes in Richtung der Mitte der Flanke des Bauteils. Vermeidung, dass Bauteile nur auf einer Kante (Ecke) des Bauteils in Kontakt mit einem anderen Bauteil sind. Damit einhergehend ist eine Verschleißminimierung.
4. Qualitätsmerkmal. Bei vielen Uhrenanwendungen werden die Bauteile sogar noch von Hand aufwändig angliert. Die Anglierung ist für den Nutzer visuell sichtbar und Uhren mit anglierten Bauteile erzielen höhere Verkaufspreise.
5. Optisches Aussehen. Die Bauteile sehen hochwertiger aus.
6. Vereinfachung und Möglichkeit der Automatisierung der Aufbautechnik. Beispielsweise vereinfacht sich Platzierung einer Achse in das Zentrale Achsloch eines Rades da die Achse durch die Fasen am Achslocheingang in das Loch geführt wird. Dies gilt grundätzlich für alle Aufbautätigkeiten (z.b. Einpressen von Lagersteinen in eine Platine oder Einsetzen eines Darts in einen Anker etc). Die Positionierung eines anglierten Bauteils (z.B. Rad) relativ zum Gegenstück (Achse, etc.) kann mit geringerer Genauigkeit (typ. +/-1µm, mit Fase +/-0,5xFasenbreite) durchgeführt werden. Damit wird auch die Automatisierung dieses Arbeitsschritts ermöglicht. Ferner werden bei diesem Arbeitsschritt weniger Bauteile beschädigt als bei Konfiguration ohne Fase. Falls die Bauteile anschließend verklebt werden, wirkt die Fase zusätzlich noch als Reservoir für überschüssigen Klebstoff.

In jüngster Zeit sind im Stand der Technik auch Uhrwerksbauteile bekannt geworden, die mikrotechnologisch hergestellt werden und aus Silizium, Glaskeramiken, Quarz, SiC, Diamant oder aus diamantbeschichteten Silizium bestehen. So sind z.B. aus der EP 1 622 826 B1 mikromechanische Uhrwerksbauteile bekannt, die aus einer ersten Oberfläche und einer hierzu als Flanke ausgebildeten zweiten Oberfläche bestehen, wobei die Flanke im Wesentlichen senkrecht zur Oberfläche ausgerichtet ist. Diese Bauteile können z.B. aus Diamant bestehen, oder damit beschichtet sein.

Ein weiteres Uhrwerksbauteil ist aus der EP1904901B1 bekannt. Die dort beschrieben Bauteile wie Zahnräder, Gangräder, Anker oder Schwenkteile bestehen aus Silizium und weisen eine Beschichtung mit Siliziumdioxid auf. Die Bauteile können auch eine zusätzliche Beschichtung mit Diamant aufweisen. Eine Anglierung wird aber nicht beschrieben.

Derartige Uhrwerksbauteile weisen Vorteile gegenüber den Uhrwerksbauteilen auf, die aus Stahl, Messing oder Buntmetallen gefertigt sind. Im Wesentlichen sind diese Vorteile darauf zurückzuführen, dass z.B. bei Uhrwerksbauteilen aus Diamant Bauteile zur Verfügung stehen, die aufgrund der stoffimmanenten Eigenschaften des Diamants eine äußerst große Härte und damit Verschleißfestigkeit aufweisen. Ferner sind die für die mikrotechnik eingesetzen Werkstoffe wie z.B. Silizum oder diamant sehr leicht (geringe Dichte). Damit können die Trägheitsmomente der rotierenden Bauteile reduziert werden und die Wirkungsgrad des Uhrwerks erhöht werden. Darüber hinaus arbeiten die Fertigungsverfahren der Mikrotechnologie kraftfrei. Damit können auch sehr filigrane und komplexe Bauteilgeometrien realisiert werden. Derartige Bauteile führen deshalb u.a. zu einer höheren Ganggenauigkeit und einer höheren Gangreserve des Uhrwerks. Da die Werkstoffe Si und C (insbesondere Diamant) auch ohne Schmierstoffe eingestetzt werden können, können die Wartungszyklen des Uhrwerks reduziert werden.

Im Stand der Technik hat es deshalb bisher nicht an Versuchen gefehlt, derartige Bauteile auch mit einer Fase auszustatten. Hier wäre z.B. das nachträgliche nasschemische Ätzen, Sandstrahlen oder die mechanische Politur zu nennen. Es hat sich aber gezeigt, dass nasschemische Angriffe nicht in kontrollierter Weise durchgeführt werden können, sodass keine Fasen entstehen die eben sind, bzw. aufgrund der komplexen Geometrie eines Uhrenbauteils z.B. der eines Ankerrades, nicht umlaufend homogen angebracht werden können. Auch kann mit den Verfahren des Standes der Technik nicht die erforderliche Oberflächenrauheit erreicht werden. Bei mechanischen Verfahren sind normalerweise hohe Kräfte erforderlich, so dass es dadurch zu Ausbrüchen der Bauteiloberfläche und im schlimmsten Fall auch zum vollständigen Bruch des Bauteils kommen kann.

Aufgabe der vorliegenden Erfindung ist es deshalb, mikromechanische Bauteile insbesondere Uhrwerksbauteile vorzuschlagen, die aus C- oder Si-enthaltenden Materialien bestehen und die eine Fase aufweisen, wobei die Fase möglichst gerade d.h. eben ausgebildet sein soll. Insbesondere die Fase des Bauteils soll auch eine verbesserte Oberflächenrauheit aufweisen. Aufgabe der vorliegenden Erfindung ist es weiterhin ein entsprechendes Verfahren zur Herstellung von derartigen mikromechanischen Uhrwerksbauteilen anzugeben.

Die Aufgabe wird im Bezug auf das Bauteil durch die Merkmale des Patentanspruches 1 und in Bezug auf das Verfahren durch die Merkmale des Patentanspruches 11 gelöst. Die Unteransprüche zeigen vorteilhafte Weiterbildungen auf.

Erfindungsgemäß wird somit ein dreidimensionales mikromechanisches Bauteil ausgewählt aus Bestandteilen des Räderwerks, Bestandteilen der Hemmung oder Bestandteilen der Unruh vorgeschlagen, das aus Silizium, SiO_{2,} Quarz, SiC, Diamant, DLC oder kristallinem Diamant besteht. Ein derartiges Bauteil weist eine erste und eine hierzu parallele zweite Oberfläche sowie mindestens eine im Wesentlichen zur ersten und zweiten Oberfläche senkrecht stehende Seitenkante auf. Erfindungsgemäß ist nun in einem derartigen dreidimensionalen mikromechanischen Bauteil mindestens bereichsweise ausgehend von mindestens einer Oberflächenkante mindestens einer Oberfläche in der/den Seitenkante/n eine Fase angeordnet ist, die ohne Maske, in einem auf dem Wafer befestigten, vorstrukturierten Uhrwerksbauteil, durch Sputtern eingebracht ist und die Fase weist dabei einen Winkel α₁ von 40° bis 65° auf und die Oberflächenrauheit der Fase (6), bezogen auf die mittlere quadratische Rauheit Rms, beträgt < 20 nm.

Damit stehen erstmalig mikromechanische Uhrwerksbauteile aus den genannten Materialien zur Verfügung die eine Fase aufweisen. Die Bauteile zeichnen sich insbesondere dadurch aus, dass die Fase gerade, d.h. eben, ausgebildet ist und dass mindestens die Fase des Bauteils eine, gegenüber dem Stand der Technik, verbesserte Oberflächenrauheit aufweist.

Da bei vielen Uhrwerksbauteilen, so z.B. bei Zahnrädern der Belastungspunkt auf der Kante liegt, kann nun durch die Fasenbildung der Belastungspunkt in Richtung der Mitte der Flanke des Bauteiles verschoben werden. Dies hat den entscheidenden Vorteil, dass das Bauteil nicht auf einer Kante (Ecke) des Bauteils mit einem anderen Bauteil in Berührung kommt, sondern dass dann der Belastungspunkt in die Mitte der Flanke des Bauteils verschoben wird. Damit geht eine Verschleißminderung einher, gleichzeitig wird die Bruchanfälligkeit verringert. Damit wird eine Erhöhung der mechanischen Stabilität und der Ganggenauigkeit der Uhrwerksbauteile erreicht.

Die Fase die in den erfindungsgemäßen Bauteilen ausgebildet ist, hat dabei bevorzugt einen Winkel α₁ von 40° bis 60° besonders bevorzugt einen Winkel α₁ im Bereich von 52° bis 56°. Die Auswahl des Winkels der Flanke wird durch die Dicke des Bauteils, d.h. durch die Waferdicke limitiert und über die Verfahrensbedingungen, insbesondere die Prozesszeit, eingestellt. Auch die breite der Fase richtet sich nach der Dicke des Bauteils. Die Fase kann problemlos bis zur Hälfte der Dicke des Bauteils reichen. Bevorzugte Breiten liegen im Bereich von 10 bis 60 µm besonders bevorzugt im Bereich von 20 bis 35 µm liegt, bei typischen Bauteildicken von beispielsweise 120µm.

Die Rauheit die bei den erfindungsgemäßen Bauteilen, insbesondere im Bereich der Flanken erreicht wird, wird durch das Bearbeitungsverfahren zur Herstellung der Flanke wie nachfolgend beschrieben eingestellt. Die Erfindung umfasst aber auch noch die Möglichkeit, dass ein nachträgliches Polieren oder Glätten der Oberfläche durchgeführt wird.

Die Erfindung umfasst insbesondere auch mikromechanische Bauteile, die ausgehend von der Fasenkante der ersten Fase mindestens eine zweite Fase aufweisen. Diese zweite Fase besitzt bevorzugt einen Winkel α₂ von 55° bis 80°, bevorzugt einen Winkel α₂ von 70° bis 78°. Die Bauteile können auch weitere Fasen aufweisen. Wobei jede weitere Fase einen größeren Winkel als die vorhergehende aufweist.

Bei den erfindungsgemäßen mikromechanischen Bauteilen kann selbstverständlich die Ausbildung der Fase in den Seitenkanten auch von beiden Oberflächen aus erfolgen. In diesem Falle wird somit eine Bearbeitung des mikromechanischen Bauteils nacheinander von beiden Oberflächenseiten aus durchgeführt, sodass sich von beiden Oberflächenkanten in Richtung der Seitenkante Fasen ausbilden.

Bei den erfindungsgemäßen Bauteilen sind von der Oberfläche aus gesehen ( Draufsicht), insbesondere diejenigen Ausführungsformen umfasst, die eine umlaufende Seitenkante aufweisen bzw. Bauteile die mehreckig ausgebildet sind und damit mehrere gerade Seitenkanten besitzen. Bevorzugt ist es dabei, wenn die Fase über die gesamte Ausdehnung der Seitenkante, d.h. einer umlaufenden Seitenkante um das ganze Bauteil herum bzw. bei den mehreckigen Bauteilen über alle geraden Seitenkanten ausgebildet ist und einen geraden d.h. ebenen Verlauf aufweist.

Ausreichend ist es jedoch in allen Fällen, wenn die Fase zumindest in den Bereichen der Seitenkante ausgebildet ist, die mit einem weiteren Bauteil im Funktionszusammenhang bringbar ist.

Die erfindungsgemäßen Bauteile werden üblicherweise aus einem scheibenförmigen Material, d.h. aus einem Wafer strukturiert. Bei einem derartigen scheibenförmigen Material sind auch dann im Bauteil die erste Oberfläche und die zweite Oberfläche parallel zueinander ausgerichtet. Die Seitenkanten stehen im Wesentlichen senkrecht, wobei Abweichungen von der senkrechten in einen Bereich von +/- 2° möglich sind.

Das erfindungsgemäße Bauteil kann dabei nicht nur aus dem Basismaterial wie vorstehend schon beschrieben bestehen, sondern dieses Basismaterial kann auch noch mit einer Beschichtung versehen sein. Insbesondere sind Bauteile bevorzugt, die aus Silizium mit und ohne Oxidschicht oder aus diamantbeschichtetem Silizium bestehen. Bei den Bauteilen, die aus diamantbeschichtetem Silizium bestehen, kann auch die Siliziumoberfläche oxidiert sein.

Die erfindungsgemäßen mikromechanischen Uhrwerksbauteile sind bevorzugt Achse, Triebe, Räder, Ankerrad, Anker, Plateau. Doppelrolle, Achse, Triebe, Unruhreif, -Achse oder Unruhfeder.

Die Erfindung betrifft weiterhin ein Verfahren zur Herstellung eines mikromechanischen Bauteils wie vorstehend beschrieben.

Beim erfindungsgemäßen Verfahren wird dabei die Fase ohne Maske in ein auf dem Wafer befestigten vorstrukturierten Bauteil durch Sputtern eingebracht. Wesentlicher Punkt des erfindungsgemäßen Verfahrens ist dabei, dass mit einer Biasspannung von > 200 V, bevorzugt von 200 V bis 1000 V gearbeitet wird. Unter Biasspannung wird hier der Betrag des negativen, elektrischen DC-Potentials der Substratelektrode im Falle eines Parallelplattenreaktors verstanden, welches sich durch die Prozessbedingungen selbst einstellt und die Energie, der im Wesentlichen senkrecht auf die Substratelektrode auftreffenden, Ionen einstellt. Um eine derartige Fase zu erzeugen muss eine, für Plasmaätzverfahren ungewöhnlich hohe Biasspannung appliziert werden. Bei üblichen Plasmaätzverfahren wird typischerweise versucht, die Biasspannung unter 200V zu halten, damit der Ionenbeschuß nicht zu Sputtereffekten der Substratelektrode führt. Die hohe Biasspannung führt nun dazu, dass die Ionen eben nicht nur das Substrat (Wafer) absputtern/anglieren, sondern auch die Substratelektrode angreifen. Somit wird das Elektrodenmaterial parasitär auf die Substratoberfläche und auch die Kammerwände gesputtert. Dieser Effekt ist unerwünscht da es die Bauteiloberflächen verunreinigt und aufwändige Reinigungszyklen von Bauteil und Prozesskammer (Rezipient) nach sich zieht. Es hat sich deshalb als vorteilhaft herausgestellt, wenn beim erfindungsgemäßen zwischen die Substratelektrode und den Wafer eine Unterlage (Suszeptor) angeordnet wird, die aus einem Material ausgewählt ist, dessen abgesputterten Rückstände kontrolliert reaktiv entfernt werden können und das die meist aus Aluminium oder anderen Metallen ausgebildete Substratelektrode vor dem Sputterangriff wird. Alternativ dazu kann auch vorgesehen sein, dass die gesputterten Rückstände selektiv und simultan aus dem Prozess entfernt werden können. Beispiele für eine derartige Unterlage ist z.B. für ein Si-Bauteil eine Unterlage aus Graphit (C).

Nachfolgend wird das Verfahren, ausgehend von einem Si-Wafer, näher beschrieben.

Gearbeitet wird ohne Maske mit vorstrukturierten Bauteilen, welche sich noch auf dem Wafer mittels Haltestegen befinden. Die Bauteile können hierbei vorzugsweise oxydiert sein. Die Oxidschicht trägt hierbei auch zum Schutz der empfindlichen Seitenflanken, welche später in Reib- oder Berührkontakt stehen bei. Der gesamte Wafer wird planar in eine RIE-Anlage, einem Plasma wie folgt ausgesetzt:
Gase: Ar/O₂; Fluss 50 sccm Ar und 2 sccm O₂; Gesamtdruck in der Kammer 10mTorr; (negative) Biasspannung 600 V ; Prozesszeit 25h

Es handelt sich um einen rein physikalischen Angriff (Sputtern) da keine reaktive Gaskomponente zugemischt wurde. Folglich ist auch der Oberflächenabtrag (*v̅_{senkrecht}*) und der laterale Abtrag (*v̅ₗₐₜₑᵣₐₗ*) vernachlässigbar gering. Der sich ausprägende Winkel der Fase beträgt ca. 40° bzw. 65°.

Wichtig ist, den Wafer auf einer Unterlage zu platzieren, welche nur kontrolliert abgesputtert wird, bzw. wessen gesputterte Rückstände des möglichst reaktiv (d.h. Isotrop), selektiv (d.h. ohne gleichzeitig das anzufasende Material mit abzutragen) und simultan (d.h. kontinuierlich während des laufenden Prozesses) wieder abgetragen werden können. Dies sowohl von den Seitenflanken der Bauteile als auch von den Kammerwänden. Dies kann z.B. durch eine Graphitunterlage erfolgen. (Deshalb auch die Beimengung von O₂ im Falle einer Graphitunterlage)
Ar/O₂/CF₄; Fluss 40sccm Ar, 10sscm O₂, 0,4sccm CF₄.; (negative) Biasspannung 830V ; Gesamtdruck in der Kammer 10mTorr, Prozesszeit 87h

Vorteil ist hier, dass die Kammer auch bezüglich abgesputterten Substratmaterialien (hier Si, bzw. SiO₂) relativ sauber bleibt. Jedoch muss mit einem Abtrag der Substratoberfläche gerechnet werden, da durch die zugabe der reaktiven Komponente CF4 nun besonders die Abtragsrate *v̅_{senkrech}* zunimmt.

Dieser Abtrag muss von vorneherein bei der Dickenauswahl der Bauteile (d.h. bei der Waferdicke) berücksichtigt und damit vorgehalten werden. Nachteilig wirkt sich aus, dass die Oberfläche der Bauteile und auch deren Seitenflanke signifikant angegriffen werden. Hieraus resultiert eine längere notwendige Prozesszeit, aber auch ggf. die Notwendigkeit eines lateralen Vorhaltes durch den Materialabtrag.

Wichtig ist bei allen o.g. Prozessen, eine hohe Biasspannung von > 200 V, bevorzugt 200 bis 1000 V, besonders bevorzugt 500 bis 900 V.

Die Erfindung wird nachfolgend anhand der Figuren näher beschrieben.
Figur 1 zeigt ausschnittsweise ein erfindungsgemäßes mikromechanisches Bauteil mit zwei Fasen
Figur 2 zeigt das gleiche Bauteil und die Verschiebung des Kontaktpunktes
Figur 3 zeigt ein weites Bauteil mit vier Fasen und
Figur 4 zeigt ein weiteres mikromechanisches Bauteil in Form eines Achslochs.
Figur 5 zeigt in der Figurenfolge 5a, b und c das Eindringen einer Achse mit Trieb und Plateau in ein angefasstes Achsloch.
Figur 6 zeigt ein Bauteil des Standes der Technik bei dem eine Fase mittels Ätzen eingebracht worden ist.
Figur 7 zeigt ein erfindungsgemäßes beschichtetes Bauteil mit einer erfindungsgemäßen Ausbildung der Fase.

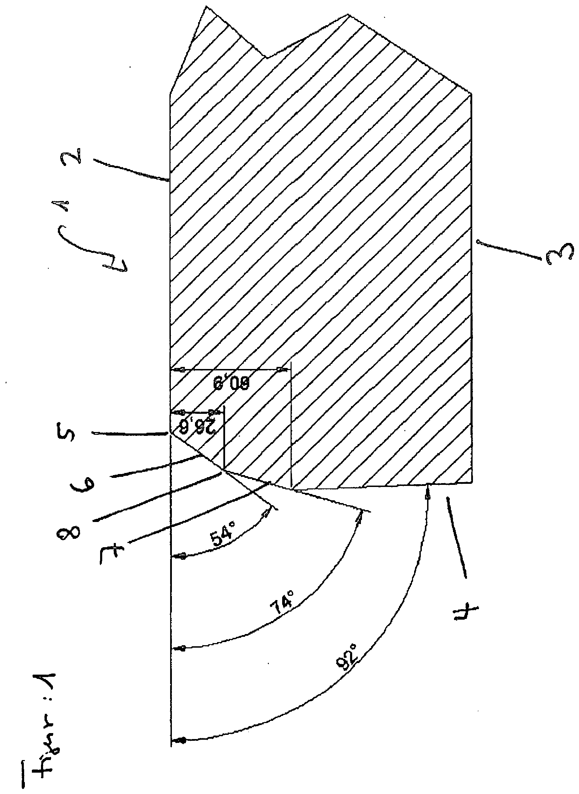

In Figur 1 ist ausschnittsweise ein mikromechanisches Bauteil 1 dargestellt. Der Ausschnitt des mikromechanischen Bauteils 1 zeigt die Aussenkontour eines Zahnrades eines Räderwerks. Das erfindungsgemäße Bauteil ist aus Silizium gefertigt. Beim erfindungsgemäßen Bauteil ist die erste Oberfläche mit 2 bezeichnet und die hierzu parallele Oberfläche mit 3. Die erste Oberfläche 2 und die zweite Oberfläche 3 sind über eine Seitenkante 4 verbunden. Wie aus der Figur 1 hervorgeht, steht die Seitenkante 4 auf der ersten Oberfläche 2 im Wesentlichen senkrecht. Im Beispielsfall weist die Seitenkante 4 einen Winkel von 92° zur ersten Oberfläche 2 auf. Erfindungsgemäß wird unter im Wesentlichen senkrecht stehend auf den Oberflächen verstanden, dass die Seitenkante 4 in einem Winkel von 90° +/- 2°, bevorzugt +/- 1° angeordnet ist. Das erfindungsgemäße Bauteil das in der Figur 1 dargestellt ist, weist eine Dicke von 155 µm auf.

In dem erfindungsgemäßen Bauteil ist nun ausgehend von der ersten Oberfläche 2 und zwar hiervon der Oberflächenkante 5 ausgehend eine erste Fase 6 angeordnet. An die Fase 6 schließt sich eine zweite Fase 7 an, die ausgehend von der Fasenkante 8 der ersten Fase ausgehend ausgebildet ist. Der Winkel α₂ der zweiten Fase 7 beträgt im Beispielsfall 74°. In Figur 1 sind weiterhin die Ausdehnungen der beiden Fasen gezeigt. Die erste Fase 6 weist eine Ausdehnung von 26,6 µm und die zweite Fase 7 eine Ausdehnung von 34,3 µm auf.

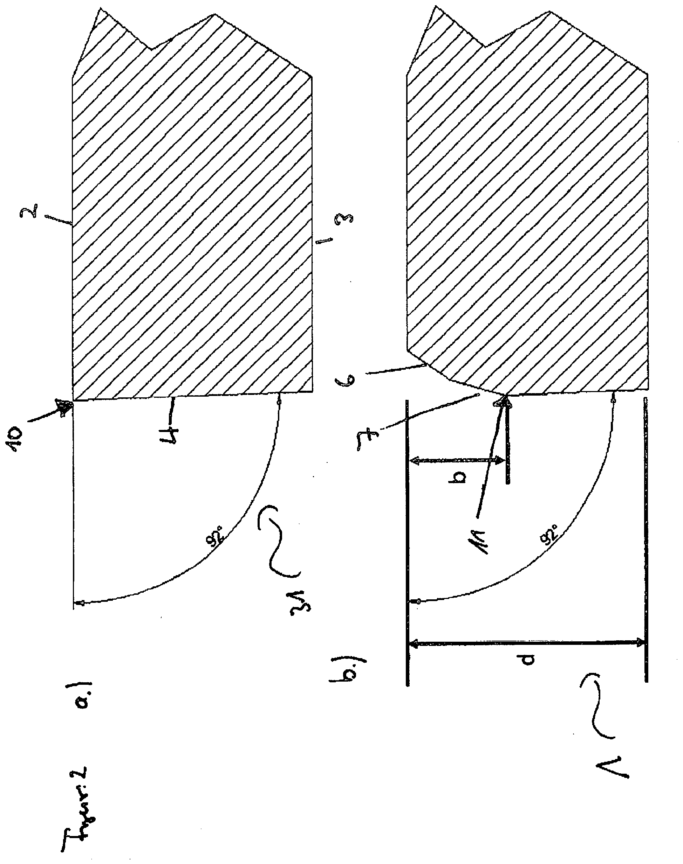

In Figur 2 ist nun dargestellt, wie sich der Kontaktpunkt verschiebt. In Figur 2a ist ein Bauteil 31 gezeigt, in dessen Seitenkante 4 keine Fase eingebracht ist. Bei einem derartigen Bauteil wird somit der Kontaktpunkt durch die Kante 10 gebildet.

Beim erfindungsgemäßen Bauteil (Figur 2b) zeigt sich nun dass der Kontaktpunkt/Kontaktlinie (ggf. umlaufend) durch die Fasenbildung auf die Fasenkante 11 verschoben wird. Dadurch wird eine deutliche Steigerung der mechanischen Belastbarkeit erreicht, da sich die Kräfteeinwirkung auf die Seitenflanke verteilen kann.
Die durch die Fase gebildete Ebene schneidet die Ebene der Seitenflanke 4 unter dem angegebenen Winkel und bildet somit die Fasenlinie 11 auf derer das Bauteil später in Berühr- oder Reibkontakt mit weiteren Bauteilen steht (typischerweise ist der Reib-/Berührpartner nicht oder nur schwach angliert). Um reibungsarme Gleiteigenschaften mit möglichst geringem Verschleiß zu erreichen, muss die Fasenlinie eine möglichst geringe Oberflächenrauheit aufweisen. Diese wird wiederum durch die Rauheit der Fasenebene und der Seitenflanke 4 defniert, Typischerweise weisen Bauteile des Standes der technik bereits auf den Seitenflanken Rauheitswerte <20nm rms auf. Hieraus resultiert die Notwendigkeit einer sehr geringen Oberflächenrauheit der Fasenebene.

Das erfindungsgemäße Bauteil das in Figur 2b gezeigt ist, weist eine Dicke d auf. Eine typische Dicke d, die durch die Dicke des Wafers vorgegeben wird, liegt im Bereich von 60 bis 500 µm. Unter Berücksichtigung der Dicke wird dann die Fasenausbildung über die Prozesszeit so gesteuertdass eine bevorzugte Fasenbreite von d/2 entsteht. In der Figur 2b sind zwei Fasen 6, 7 eingebracht, wobei die gesamte Breite beider Fasen durch b definiert ist. Figur 2b macht auch deutlich, dass die
Wahl der Fasenbreite und letztlich auch des Fasenwinkels von der Dicke des Wafers abhängt. Die Einstellung sowohl des Winkels wie auch dann der Breite der Fase wird dann letztlich durch die Verfahrensbedingungen realisiert.

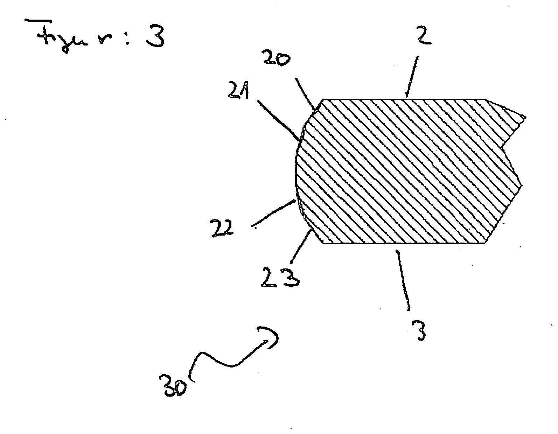

Figur 3 zeigt nun ein weiteres, erfindungsgemäßen mikromechanisches Bauteil wiederum ausschnittsweise. Das erfindungsgemäße Bauteil 30 ist wiederum nur ausschnittsweise dargestellt. Das Bauteil, das in der Figur 3 abgebildet ist, ist vergleichbar mit dem Bauteil nach Figur 1. Der Unterschied besteht nun darin, dass dieses Bauteil von beiden Oberflächenseiten aus, nämlich von der Oberflächenseite aus 2 und von der Oberflächenseite aus 3 mit Fasen versehen worden ist. Bei der Herstellung wurde dieses Bauteil einfach einmal gedreht und dann wiederum von der zweiten Oberflächenseite, hier von der Oberflächenseite 3 aus bearbeitet. In Folge dessen entsteht dann ein Bauteil, das vier Fasen, 20, 21 und 22, 23 aufweist. In diesem Fall sind die Fasen auf beiden Seiten symmetrisch. Falls gewünscht können aber auch asymmetrische Fasen erzeugt werden.

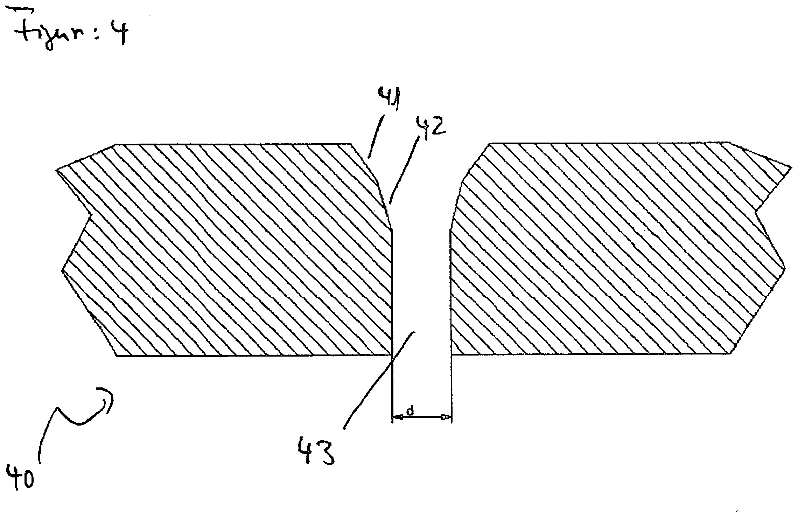

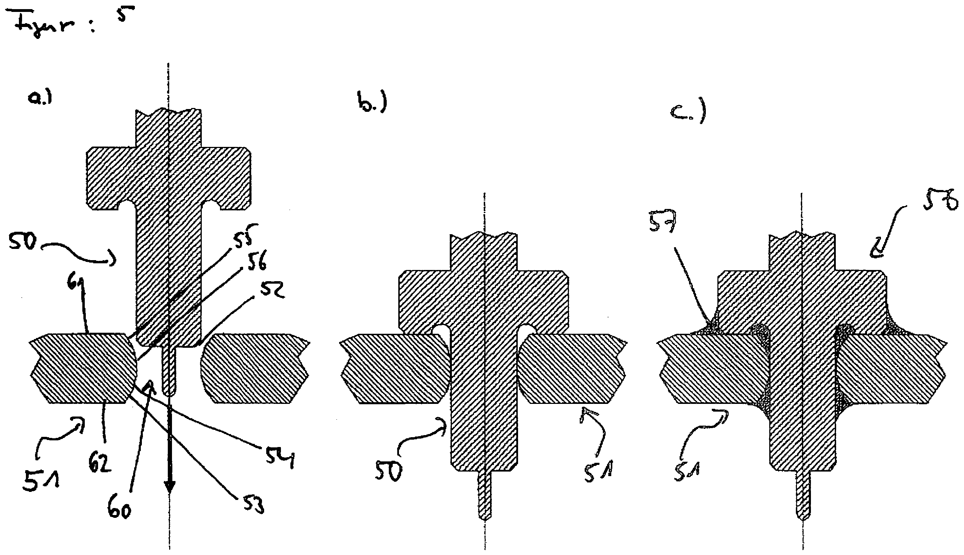

Figur 4 zeigt schematisch einen Schnitt durch den Teilausschnitt eine Rades 40 mit einem Achsloch 43. Dadurch dass nun bei dem Bauteil 40 wiederum zwei Fasen 41 und 42 vorgesehen sind, ist es problemlos möglich, eine Achse in dem Achsloch 43 zu zentrieren. Dadurch dann nun erfindungsgemäß das Bauteil wie in Figur 4 gezeigt gefast ist, erfolgt eine automatische Zentrierung der Achse im Achsloch 43. Dadurch wird nicht nur eine einfache Montage erreicht, sondern die Achse ist auch in diesem Fall optimal zentriert und befestigt. Dies ist in Figur 5 gezeigt. Figur 5 zeigt nun in der Figurenabfolge 5a, b und c wie eine Achse mit Trieb und Plateau in ein Achsloch z.B. eines Rades 51 mit einer erfindungsgemäßen Anfasung eingebracht wird. In der Figur 5a sind die beiden Bauteile 51 und 50 im noch nicht montierten Zustand gezeigt. Mit 50 ist eine Achse mit Trieb und Plateau bezeichnet. Diese Achse verfügt ebenfalls über eine Anfasung 52. Diese Achse mit Trieb und Plateau wird dann in das Achsloch 60 eingeführt. Erfindungsgemäß ist dieses Achsloch 60, das zum Beispiel das Achsloch 60 eines Rades sein kann, so ausgebildet, dass das Achsloch 60 selbst wiederum eine Anfasung 55 und 56 aufweist. In der Figur 4 ist eine entsprechende Ausbildung in Vergrößerung dargestellt. Im Unterschied zur Ausführungsform nach der Figur 4, weist das mikromechanische Bauteil 51 nicht nur eine Anfasung 55, 56 ausgehend von der ersten Oberflächenseite 61 auf, sondern gleichzeitig noch eine Anfasung 53, 54, auf die von der gegenüberliegenden Oberfläche 62 ausgehend, eingebracht worden ist. Wesentlich bei den erfindungsgemäßen Bauteilen ist nun, dass es mit der Anfasung 55, 56 und der Anfasung 52 der Achse 50 möglich ist, die Achse problemlos im Achsloch 60 zu zentrieren. Durch die Anfasungen wird eine Art "Zwangsführung" der Achse im Achsloch 60 erreicht, sodass eine schnelle Montage ein problemloser und sicherer Halt der Achse 50 im Achsloch 60 des mikromechanischen Bauteils 51 erreicht werden kann. Der Zustand nach Einführung der Achse in das Achsloch 60 ist in der Figur 5b dargestellt.

Figur 5c zeigt nur noch eine zusätzliche Ausführungsform, bei der dann noch durch Klebstoff (oder Lot) ein Verschließen der durch die Anfasung entstehenden Lücken vorsieht. Der Klebstoff ist in der Figur 5c mit 57 bezeichnet.

Figur 5 macht besonders deutlich, dass durch die Verwendung der angefasten mikromechanischen Bauteile nach der Erfindung weitreichende Vorteile verbunden sind. Am Beispiel der Achse mit dem Achsloch wird verdeutlicht, dass nicht nur ein vereinfachtes Einführen der Achse in das Achsloch möglich ist, sondern die Achse ist völlig zentriert und im rechten Winkel im Bezug zur Oberfläche 61 exakt im Achsloch angeordnet. Es wird somit ein fester, sicherer und exakter Halt der Achse im Achsloch erreicht.

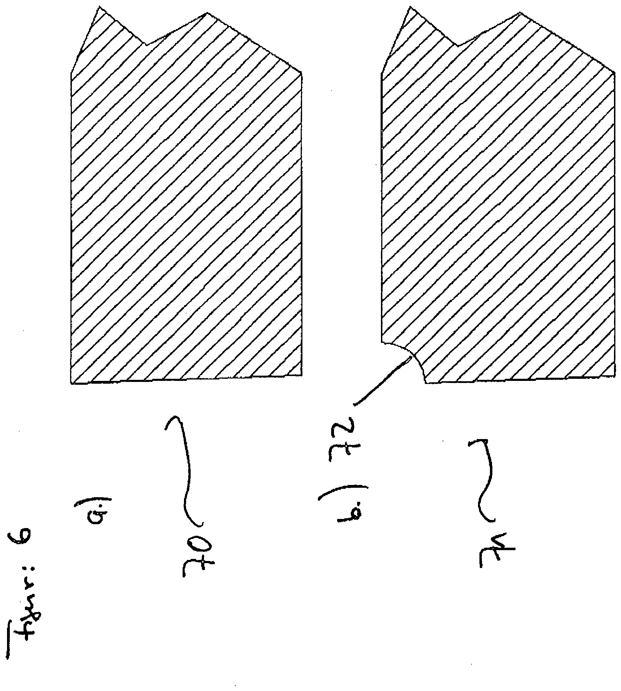

Figur 6 zeigt ebenfalls ausschnittsweise ein angefastes Bauteiles des Standes der Technik. Wie bereits eingangs in der Beschreibungseinleitung erläutert, ist es bisher im Stand der Technik bekannt, auch Anfasungen von Bauteilen vorzunehmen, jedoch wird dies im Regelfall durch einen isotropen Ätzangriff, d.h. durch einen chemischen Ätzangriff erreicht. In Figur 6a ist ein unbehandeltes Bauteil des Standes der Technik dargestellt, und in Figur 6b ein behandeltes Bauteil, wobei ein chemischer Ätzangriff durchgeführt worden ist. Wie die Figur 6b zeigt, bildet sich durch den chemischen Ätzangriff bei den Bauteilen des Standes der Technik keine ebene planare Fase aus, sondern die Fase besitzt entweder eine konvexe oder eine konkave Form. Im Beispielsfall nach der Figur 6, ist eine konkave Ausführungsform dargestellt. Üblicherweise weisen die Oberlfächen derartiger Fasen eine hohe, nicht tolerierbare Oberflächenrauheit auf, welche letztendlich in einer großen Rauheit der Fasenkante (Schnitt Fasenebene, Seitenflanke) resultiert.

Ein Vergleich dieses Bauteiles des Standes der Technik mit der Erfindung macht deutlich, dass mit einer derartigen Fase in keinem Falle die Ergebnisse erreicht werden können, wie dies mit einer völlig ebenen planaren Fase möglich ist. Eine derartige Fase 72 ist gegenüber der erfindungsgemäßen Fase deutlich bruchanfälliger und zeigt zusätzlich einen viel größeren Verschleiß.

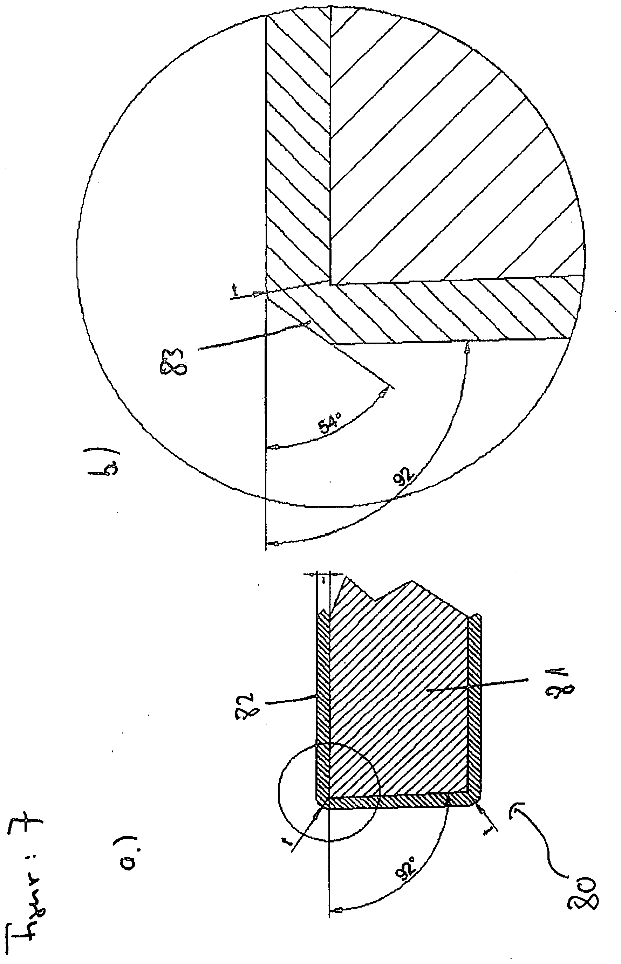

In Figur 7 ist ein weiteres erfindungsgemäßes Bauteil 80 dargestellt. Figur 7b zeigt hierbei die vergrößerte Darstellung, Figur 7a zeigt ein erfindungsgemäßes Bauteil 80, das aus einem Siliziummaterial 81 besteht. Das Siliziumbauteil 80 ist mit einer Diamant- oder Siliziumdioxidschicht 82 mit der Stärke t versehen.

Wie aus der Figur 7b hervorgeht, entsteht durch die Anfasung 83 mit einem Fasenwinkel von 54° eine völlig ebene planare Fase. Wie die Figur 7b zeigt, ist die Fase nun hier ausschließlich in der Diamant- oder Siliziumoxidschicht 82 mit der Stärke t eingebracht.

## Patentansprüche

1. Dreidimensionales, mikromechanisches Uhrwerksbauteil (1) ausgewählt aus Bestandteilen des Räderwerks, Bestandteilen der Hemmung oder Bestandteilen der Unruh aus Silizium, SiO₂, Quarz, SiC, Diamant, DLC oder kristallinem Diamant mit einer ersten (2) und einer hierzu parallelen zweiten (3) Oberfläche sowie mindestens einer Seitenflanke (4), wobei mindestens bereichsweise ausgehend mindestens von einer Oberflächenkante mindestens einer Oberfläche, in der/den Seitenflanke/n (4) eine Fase (6) angeordnet ist, die ohne Maske, in einem auf dem Wafer befestigten, vorstrukturierten Uhrwerksbauteil, durch Sputtern eingebracht ist und einen Winkel α₁ von 40° bis 65° aufweist und die Oberflächenrauheit der Fase (6), bezogen auf die mittlere quadratische Rauheit Rms, < 20 nm beträgt.

2. Mikromechanisches Uhrwerksbauteil nach Anspruch 1, **dadurch gekennzeichnet, dass** ausgehend von der Fasenkante (8) der Fase (6) mindestens eine zweite Fase (7) angeordnet ist, wobei die zweite Fase einen Winkel α₂ von 55° bis 80° zur Oberfläche der ersten Fase (6) aufweist.

3. Mikromechanisches Uhrwerksbauteil nach mindestens einem der Ansprüche 1 oder 2, **dadurch gekennzeichnet, dass** das mikromechanische Uhrwerksbauteil (1) eine umlaufende Seitenflanke (4) aufweist und die Fase/n (6, 7) bevorzugt in dem Bereich der Seitenflanke (4) angeordnet ist/sind, die in Funktionszusammenhang mit einem weiteren Bauteil bringbar ist/sind.

4. Mikromechanisches Uhrwerksbauteil nach mindestens einem der Ansprüche 1 oder 2, **dadurch gekennzeichnet, dass** das mikromechanische Uhrwerksbauteil (1) mehreckig ist und die Fase/n (6, 7) in mindestens einer Seitenflanke (4) angeordnet ist/sind, die in Funktionszusammenhang mit einem weiteren Bauteil bringbar ist/sind.

5. Mikromechanisches Uhrwerksbauteil nach mindestens einem der Ansprüche 1 bis 4, **dadurch gekennzeichnet, dass** die Fase/n (6, 7) über die gesamte Ausdehnung der Seitenflanke in den Seitenflanken (4) angeordnet sind.

6. Mikromechanisches Uhrwerksbauteil nach mindestens einem der Ansprüche 1 bis 5, **dadurch gekennzeichnet, dass** das Uhrwerksbauteil (1) aus einem scheibenförmigen Material mit im Wesentlichen senkrechten Seitenflanke (4) strukturiert worden ist.

7. Mikromechanisches Uhrwerksbauteil nach mindestens einem der Ansprüche 1 bis 6, **dadurch gekennzeichnet, dass** das Bauteil (1) eine Dicke von 50 µm bis 500 µm, bevorzugt von 100 µm bis 300 µm aufweist.

8. Mikromechanisches Bauteil nach mindestens einem der Ansprüche 1 bis 7, **dadurch gekennzeichnet, dass** mindestens eine Oberfläche (2, 3) und/oder Seitenflanke (4) und/oder Fase/n (6, 7), des Uhrwerksbauteils mindestens bereichsweise mit einer Beschichtung versehen ist.

9. Mikromechanisches Uhrwerksbauteil nach Anspruch 8, **dadurch gekennzeichnet, dass** das Silizium mindestens bereichsweise mit einer Oxidschicht und/oder mit einer Diamantbeschichtung versehen ist.

10. Verfahren zur Herstellung eines mikromechanischen Uhrwerksbauteils nach mindestens einem der Ansprüche 1 bis 9, **dadurch gekennzeichnet, dass** die Fase/n (6, 7), ohne Maske, in einem auf dem Wafer befestigten, vorstrukturierten Uhrwerksbauteil, durch Sputtern eingebracht sind.

11. Verfahren nach Anspruch 10, **dadurch gekennzeichnet, dass** mit einer negativen Biasspannung von > 200 V, bevorzugt 200 V bis 1000 V gearbeitet wird.

12. Verfahren nach Anspruch 10 oder 11, **dadurch gekennzeichnet, dass** der Wafer auf einer Unterlage angeordnet wird die so ausgewählt wird, dass deren gesputterte Rückstände kontrolliert abgesputtert werden können oder dessen gesputterte Rückstände selektiv und simultan aus dem Prozess entfernt werden.

## Claims

1. Three-dimensional, micromechanical clockwork component (1) selected from elements of the gear train, elements of the escapement, or elements of the balance made from silicon, SiO₂, quartz, SiC, diamond, DLC, or of crystalline diamond, having a first (2) surface and a second (3) surface which is parallel to this as well as at least one side flank (4), wherein at least in regions starting at least from one surface edge of at least one surface, a chamfer (6) is arranged in the side flank(s) (4), said chamfer, without a mask, is introduced into a pre-structured clockwork component which is attached to the wafer by means of sputtering and said chamfer having an angle α₁ of 40° to 65° and the surface roughness of the chamfer (6), with regard to the average square roughness Rms, is < 20nm.

2. Micromechanical clockwork component according to claim 1, **characterised in that**, starting from the chamfered edge (8) of the chamfer (6), at least one second chamfer (7) is arranged, wherein the second chamfer has an angle α₂ of 55° to 80° with respect to the surface of the first chamfer (6).

3. Micromechanical clockwork component according to claim 1 or 2, **characterised in that** the micromechanical clockwork component (1) has a circumferential side flank (4) and the chamfer(s) (6, 7) is/are preferably arranged in the region of the side flank (4), which is/are able to be engaged in a functional relationship with a further component.

4. Micromechanical clockwork component according to claim 1 or 2, **characterised in that** the micromechanical clockwork component (1) is polygonal and the chamfer(s) (6, 7) is/are arranged in at least one side flank (4), which is/are able to be engaged in a functional relationship with a further component.

5. Micromechanical clockwork component according to at least one of claims 1 to 4, **characterised in that** the chamfer(s) (6, 7) are arranged in the side flanks (4) over the entire extent of the side flank.

6. Micromechanical clockwork component according to at least one of claims 1 to 5, **characterised in that** the clockwork component (1) has been structured from a disc-shaped material having substantially perpendicular side flanks (4).

7. Micromechanical clockwork component according to at least one of claims 1 to 6, **characterised in that** the component (1) has a thickness of 50µm to 500µm, preferably 100µm to 300µm.

8. Micromechanical component according to at least one of claims 1 to 7, **characterised in that** at least one surface (2, 3) and/or side flank (4) and/or chamfer(s) (6, 7) of the clockwork component is provided with a coating at least in regions.

9. Micromechanical clockwork component according to claim 8, **characterised in that** the silicon is provided, at least in regions, with an oxide layer and/or with a diamond coating.

10. Method for the production of a micromechanical clockwork component according to at least one of claims 1 to 9, **characterised in that** the chamfer(s) (6, 7), without a mask, are introduced into a pre-structured clockwork component which is attached to the wafer by means of sputtering.

11. Method according to claim 10, **characterised in that** work is carried out using a negative bias voltage of <200V, preferably 200V to 1000V.

12. Method according to claim 10 or 11, **characterised in that** the wafer is arranged on a base which is selected such that its sputtered residues can be sputtered in a controlled manner or its sputtered residues can be removed from the process in a selective and simultaneous manner.

## Revendications

1. Composant d'horlogerie tridimensionnel micro-mécanique (1) sélectionné parmi des composants du rouage, des composants de l'échappement ou de composants du balancier en silicium, SiO₂, quartz, SiC, diamant, DLC ou diamant cristallin, avec une première surface (2) et une deuxième surface (3) parallèle à celle-ci ainsi qu'au moins un flanc latéral (4), dans lequel, au moins à certains endroits, à partir d'au moins une arête de surface d'au moins une surface, dans le(s) flanc(s) latéral/latéraux (4), se trouve un chanfrein (6) qui est réalisé sans masque, dans un composant d'horlogerie pré-structuré fixé dans la tranche, par pulvérisation et qui présente un angle α₁ de 40° à 65° et la rugosité de surface du chanfrein (6) est, en ce qui concerne la rugosité carrée moyenne Rms, < 20 nm.

2. Composant d'horlogerie micro-mécanique selon la revendication 1, **caractérisé en ce que**, à partir de l'arête (8) du chanfrein (6), se trouve au moins un deuxième chanfrein (7), le deuxième chanfrein formant, avec la surface du premier chanfrein (6), un angle α₂ de 55° à 80°.

3. Composant d'horlogerie micro-mécanique selon au moins l'une des revendications 1 ou 2, **caractérisé en ce que** le composant d'horlogerie micro-mécanique (1) comprend un flanc latéral circulaire (4) et le(s) chanfrein(s) (6, 7) est/sont disposé(s) au niveau du flanc latéral (4), qui peut/peuvent être mis en relation fonctionnelle avec un autre composant.

4. Composant d'horlogerie micro-mécanique selon au moins l'une des revendications 1 ou 2, **caractérisé en ce que** le composant d'horlogerie micro-mécanique (1) est polygonal et le(s) chanfrein(s) (6, 7) est/sont disposé(s) dans au moins un flanc latéral (4), qui peut/peuvent être mis en relation fonctionnelle avec un autre composant.

5. Composant d'horlogerie micro-mécanique selon au moins l'une des revendications 1 à 4, **caractérisé en ce que** le(s) chanfrein(s) (6, 7) est/sont disposé(s) sur toute l'extension du flanc latéral dans les flancs latéraux (4).

6. Composant d'horlogerie micro-mécanique selon au moins l'une des revendications 1 à 5, **caractérisé en ce que** le composant d'horlogerie (1) a été structuré à partir d'un matériau en forme de disque avec un flanc latéral (4) globalement perpendiculaire.

7. Composant d'horlogerie micro-mécanique selon au moins l'une des revendications 1 à 6, **caractérisé en ce que** le composant (1) présente une épaisseur de 50 µm à 500 µm, de préférence de 100 µm à 300 µm.

8. Composant d'horlogerie micro-mécanique selon au moins l'une des revendications 1 à 7, **caractérisé en ce qu'**au moins une surface (2, 3) et/ou un flanc latéral (4) et/ou un/des chanfrein/s (6, 7), du composant d'horlogerie est muni, au moins à certains endroits, d'un revêtement.

9. Composant d'horlogerie micro-mécanique selon la revendication 8, **caractérisé en ce que** le silicium est muni, au moins à certains endroits, d'une couche d'oxyde et/ou d'un revêtement de diamant.

10. Procédé de fabrication d'un composant d'horlogerie micro-mécanique selon au moins l'une des revendications 1 à 9, **caractérisé en ce que** le(s) chanfrein(s) (6, 7) est/sont réalisé(s) sans masque, dans un composant d'horlogerie pré-structuré fixé sur la tranche, par pulvérisation.

11. Procédé selon la revendication 10, **caractérisé en ce que** le travail s'effectue avec une tension de polarisation négative > 200 V, de préférence de 200 V à 1000 V.

12. Procédé selon la revendication 10 ou 11, **caractérisé en ce que** la tranche est disposée sur un support choisi de façon à ce que ses résidus pulvérisés puissent être pulvérisés de manière contrôlée ou ses résidus pulvérisés soient retirés de manière sélective et simultanée du processus.
